(19) **Europäisches Patentamt**

**European Patent Office**

**Office européen des brevets**

(11) **EP 1 253 758 B1**

(12) **FASCICULE DE BREVET EUROPEEN**

(45) Date de publication et mention
de la délivrance du brevet:
**19.01.2005 Bulletin 2005/03**

(51) Int Cl.⁷: **H04L 27/20**, H03D 7/16

(21) Numéro de dépôt: **02291002.0**

(22) Date de dépôt: **19.04.2002**

(54) **Procédé de génération de modulation par division de fréquence suivi de multiplication de fréquence et équipement radiofréquence**

Verfahren zur Modulation durch Frequenzteilung gefolgt durch Frequenzmultiplikation, und entsprechende Radiofrequenz-Vorrichtung

Method of modulation by frequency division followed by frequency multiplication, and corresponding radio frequency device

(84) Etats contractants désignés:
**AT BE CH CY DE DK ES FI FR GB GR IE IT LI LU MC NL PT SE TR**

(30) Priorité: **27.04.2001 FR 0105730**

(43) Date de publication de la demande:
**30.10.2002 Bulletin 2002/44**

(73) Titulaire: **Thales**
**75008 Paris (FR)**

(72) Inventeurs:
• **Collin, Laurent, Thales, Intellectual Property
94117 Arcueil Cedex (FR)**
• **Boutigny, Pierre-Henri, Thales, Intellectual Prop.
94117 Arcueil Cedex (FR)**
• **Triquenaux, Denis, Thales, Intellectual Property
94117 Arcueil Cedex (FR)**

(74) Mandataire: **Dudouit, Isabelle
THALES Intellectual Property,
31-33 avenue Aristide Briand
94117 Arcueil Cedex (FR)**

(56) Documents cités:
**EP-A- 0 369 832         US-A- 5 903 609
US-A- 6 026 307**

## Description

La présente invention concerne un équipement de radiocommunication comportant des moyens adaptés pour appliquer un coefficient à un ou à plusieurs signaux utiles.

L'expression "signal utile" désigne dans la suite de la description un signal porteur de l'information.

Le coefficient peut être un coefficient de multiplication ou encore un coefficient de division.

L'équipement de radiocommunication comporte, par exemple, un émetteur et/ou un récepteur, l'un des deux au moins comprend les moyens de division et/ou de multiplication.

Elle s'applique dans le cas de modulation en phase et/ou de modulation de fréquence.

Elle concerne notamment les équipements de radiocommunication, (faisceaux hertziens, liaisons point à point, liaisons point - multipoint, ...), en particulier des équipements fonctionnant en bande de fréquences millimétriques.

Dans les équipements de radiocommunication, la chaîne d'émission de fréquence comporte généralement un dispositif pour transposer la fréquence du signal utile porteur de l'information en bande radiofréquence. La fréquence $F_{ol}$ de l'oscillateur local se trouve donc être du même ordre de grandeur que la fréquence d'émission $F_e$. Dans le domaine millimétrique, notamment, ceci implique de développer des fonctions dans des gammes de fréquence qui sont difficiles à réaliser.

Il est aussi connu des chaînes d'émission où l'étape de multiplication en fréquence est effectuée sur le signal de transposition en fréquence.

Le brevet US-A-US 6 026 307 décrit un système de communication pour transmettre des signaux dans différentes bandes de fréquence. Le problème technique résolu dans ce brevet est de produire une première bande de fréquence ayant une première fréquence centrale et une deuxième bande de fréquence ayant une deuxième fréquence centrale où la deuxième fréquence centrale est deux fois plus élevée sans pour autant doubler la largeur de bande de modulation, à partir d'un circuit comprenant uniquement 2 VCO (colonne 2 lignes 56-64).

Le brevet US 5 903 609 décrit un système de transmission pour transmettre des symboles numériques par une modulation basée sur une constellation de phase. Le système inclut un émetteur ayant un modulateur de phase et un multiplicateur de fréquence en cascade pour produire un signal modulé ayant une fréquence de transmission désirée. Pour empêcher la dégradation du taux d'erreur binaire d'un tel signal, la constellation de phase à l'entrée du modulateur de phase a au moins un état additionnel de phase relativement à la constellation de phase à la sortie du multiplicateur de fréquence.

L'idée de l'invention repose sur une structure d'un émetteur et/ou d'un récepteur intégrant des dispositifs adaptés à appliquer un coefficient diviseur et un coefficient multiplicateur sur un ou plusieurs signaux utiles.

De plus, la structure comporte des moyens adaptés à améliorer la symétrie de la densité spectrale de puissance obtenue par ce procédé et permet une optimisation des signaux modulants en bande de base pour réaliser un filtrage à l'émission de la densité spectrale de puissance du signal modulant initial.

L'objet de l'invention concerne un équipement de radiofréquence selon la revendication 1, et un procédé d'émission selon la revendication 3.

L'invention offre notamment les avantages suivants:

- Une simplification de l'architecture de la partie haute fréquence d'une chaîne d'émission.
- L'utilisation d'un minimum de composants dans la partie radiofréquence de l'émetteur, par exemple.
- Une précision de réalisation de la modulation initiale qui est du même ordre de grandeur que la précision requise sur la modulation en sortie de la multiplication si le rapport de division sur la modulation initiale est identique au rapport de multiplication.
- Une transposition de la modulation en sortie du diviseur qui permet d'augmenter la fréquence du signal utile divisé avant de le multiplier et donc d'obtenir en sortie du multiplieur, un signal d'émission vers les hyperfréquences ou les fréquences millimétriques avec un rapport de multiplication raisonnable.
- Une optimisation de la symétrie du spectre émis et un filtrage de la densité de puissance du signal utile en optimisant le formant des signaux en phase et en quadrature du modulateur réalisant la modulation initiale.

D'autres avantages et caractéristiques de l'invention apparaîtront mieux à la lecture de la description qui suit donnée à titre illustratif et nullement limitatif en relation des figures qui représentent :

- La figure 1 un schéma d'une chaîne d'émission comprenant un dispositif de multiplication selon l'art antérieur,
- La figure 2 une première structure d'une chaîne d'émission selon l'invention incluant un diviseur du signal utile,
- La figure 3 une deuxième structure d'une chaîne d'émission,
- La figure 4 une variante de réalisation combinant les structures des figures 2 et 3,
- Les figures 5 à 12 des exemples de signaux et de spectre obtenus avec la structure selon l'invention.

**EP 1 253 758 B1**

De manière à mieux faire comprendre l'objet de l'invention, la description qui suit, donnée à titre illustratif et nullement limitatif, concerne une chaîne d'émission d'un équipement radiofréquence intégrant un dispositif adapté à effectuer une division de fréquence du signal utile et un dispositif adapté à effectuer une multiplication de fréquence du signal utile divisé et transposé en fréquence.

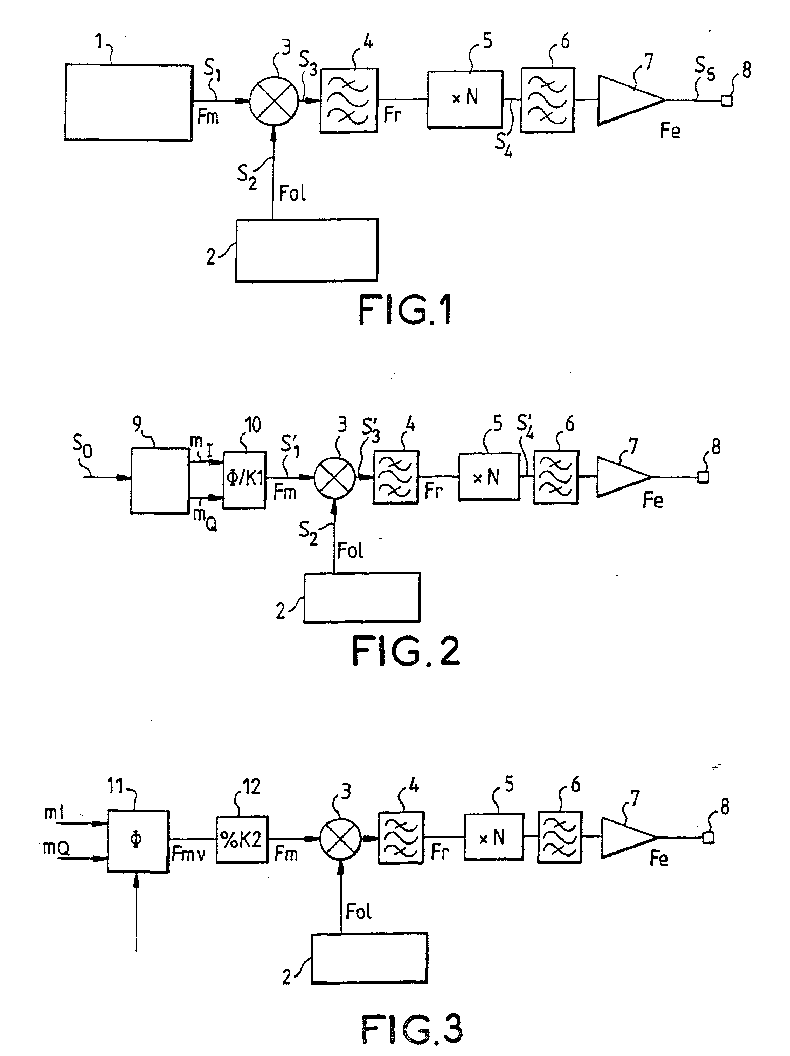

La figure 1 représente un exemple d'une chaîne d'émission d'un équipement radiofréquence incluant un dispositif de multiplication en fréquence du signal utile.

Elle comporte un modulateur 1 fournissant un signal utile $S_1$ porteur de l'information, modulé en phase et de fréquence $F_m$, un oscillateur local 2 à une fréquence $F_{ol}$, un mélangeur 3 recevant le signal utile modulé $S_1$ et le signal $S_2$ à la fréquence $F_{ol}$ afin de les mélanger et produire un signal $S_3$ à la fréquence $F_r$ sensiblement égale ou égale à $(F_m + F_{ol})$ ou $(F_m - F_{ol})$. Ce signal $S_3$ transposé en fréquence est envoyé vers un filtre passe bande 4 puis vers un dispositif 5 adapté à multiplier $S_3$ par un coefficient N de façon à produire un signal $S_4$ à la fréquence d'émission $F_e$, (avec $F_e = N(F_{ol} + F_m)$ ou $F_e = N(F_{ol} - F_m)$ ). Le signal multiplié est ensuite transmis à un deuxième filtre passe bande 6 puis à un amplificateur 7 permettant de lui donner la puissance suffisante pour son émission, en sortie de l'antenne 8, signal $S_5$.

Dans le cas où le signal utile à la sortie de l'antenne doit être un signal à la fréquence $F_e$ modulé par des sauts de phase i*(2*π/m) correspondant au codage des données numériques à transmettre, où m est le nombre d'états de la modulation de phase, les sauts de phase au niveau de l'antenne valent :

$$i \times \frac{2\pi}{m} \text{ avec i} \in [0,...,\text{m-1}], \text{ ou } \pm(2i+1) \times \frac{\pi}{m} \text{ avec i} \in [0,...,(\text{m/2})\text{-1}], \tag{1}$$

Le coefficient m est fonction de la modulation à émettre. Si $m=2^r$, où r est un coefficient dépendant de la modulation de phase utilisée, nous retrouvons par exemple la modulation de phase BPSK (Bit phase Shift Keying) pour r=1 et m=2 et la modulation QPSK (Quadrature Phase Shift Keying) pour r=2 et m=4.

Cette modulation de phase est la modulation de phase réalisée en sortie du multiplieur par N, N étant le facteur de multiplication. La multiplication par N d'un signal de fréquence $F_r$ et de phase initiale $\phi_{0r}$ crée une fréquence d'émission $F_e = N * F_r$ et une rotation de phase de $N * \phi_{0r}$.

Par conséquent, il est possible d'obtenir la modulation à la fréquence $F_e$ modulé par des sauts de phase i* (2*π/m), si la modulation à la fréquence $F_r$ est modulé par des sauts de phase i*(2*π/m)/N.

Dans ce cas, les sauts de phase au niveau du signal de fréquence $F_r$ valent:

$$i \times \frac{2\pi/m}{N} \text{ avec i} \in [0,...,\text{m-1}], \text{ ou } \pm(2i+1) \times \frac{\pi/m}{N} \text{ avec i} \in [0,...,(\text{m/2})\text{-1}], \tag{2}$$

Dans le cas où le signal de fréquence $F_r$ est issu d'une transposition du signal à la fréquence $F_m$, modulé en phase avec un oscillateur local $F_{ol}$, la modulation de phase du signal $F_m$ est identique à la modulation de phase du signal $F_r$. En sortie de transposition, la fréquence $F_r$ est égale à $(F_{ol} + F_m)$ ou $(F_{ol} - F_m)$ suivant le filtrage utilisé en sortie du mélangeur réalisant la transposition.

Les sauts de phase au niveau du signal $F_m$ sont donc identiques aux sauts de phase au niveau de $F_r$ qui sont nécessaires pour obtenir la modulation de phase i*(2*π/m) souhaitée au niveau de l'antenne. Ces sauts de phase valent donc au niveau du signal modulé $F_m$:

$$i \times \frac{2\pi/m}{N} \text{ avec i} \in [0,...,\text{m-1}], \text{ ou } \pm(2i+1) \times \frac{\pi/m}{N} \text{ avec i} \in [0,...,(\text{m/2})\text{-1}], \tag{3}$$

Cette modulation permettant d'obtenir la modulation de phase i*(2*π/m) après multiplication par N, n'est pas la seule possible. Notamment, si N est impair et supérieur à m-1, des sauts de phase de i*(2*π/m) deviennent des sauts de phase N*i*(2*π/m) en sortie de multiplication par N: tous les états modulo 2π sont retrouvés en sortie de multiplication par N.

Une modulation de phase peut être par exemple générée par un modulateur vectoriel qui permet de sommer deux modulations issues d'un même oscillateur mais déphasées de π/2, à partir de deux signaux modulants $m_I(t)$ et $m_Q(t)$ liés au message à transmettre.

Plusieurs dispositifs permettent d'obtenir une modulation avec des sauts de phase de type $i \times \frac{2\pi/m}{N}$ ou $\pm(2i+1) \times \frac{\pi/m}{N}$.

Dans la suite de la description, les références identiques désignent des éléments similaires.

La figure 2 schématise un exemple de structure d'un émetteur selon l'invention comprenant des moyens qui permettent de diviser le signal utile avant de le multiplier dans une chaîne telle que celle décrite à la figure 1.

L'émetteur comporte différents éléments qui peuvent être regroupés en deux blocs I et II. Le premier bloc I a notamment pour fonction de moduler et de diviser le signal à émettre alors que le bloc II a pour fonction de multiplier et d'amplifier le signal divisé et transposé S'$_3$ avant son émission. Les deux blocs peuvent faire partie d'un même dispositif ou être distincts.

Le message binaire S$_0$ à émettre est tout d'abord décomposé en deux signaux élémentaires modulants m$_Q$ et m$_I$ en appliquant une fonction formant(t) 9. Une fonction formant (t) correspond à une relation élémentaire qui permet de passer d'un état à un autre. Cette fonction est définie sur la durée d'un bit du signal S$_0$ et son amplitude est normalisée à 1. Ceci s'applique bien entendu pour les messages numériques ou analogiques.

Les signaux modulants élémentaires sont ensuite transmis à un modulateur vectoriel 10 intégrant un diviseur de phase, de coefficient K$_1$.

Les signaux modulants m$_I$ et m$_Q$ liés au message à transmettre sont tels que (5) :

$$m_e + j\,m_Q = 1 \times \exp\left( j \pm (2i+1) \times \frac{\pi/m}{K_1} \right)$$

avec K$_1$ = N ou K$_1$ sensiblement égal à N avec N le facteur de multiplication de la multiplication, entier pair ou impair.

La figure 3 schématise une seconde variante de réalisation d'un dispositif permettant cette même modulation. Dans ce cas, le modulateur vectoriel 11 est associé à un diviseur de fréquence 12 placé entre celui-ci et le mélangeur de transposition 3. Ce diviseur de fréquence 12 permet de diviser le signal utile de fréquence F$_{mv}$ en sortie du modulateur vectoriel 11 par un coefficient K$_2$ égal ou sensiblement égal à N, avant d'effectuer l'opération de mélange avec la fréquence F$_{0l}$ issue de l'oscillateur local puis la multiplication par N. Les signaux modulants m$_I$ et m$_Q$ liés au message à transmettre sont déterminés à partir de l'expression (5) avec K$_1$ = 1.

La division par K$_2$ d'un signal de fréquence F$_{mv}$ et de phase initiale $\phi_{mv}$ crée une fréquence de modulation F$_m$ = F$_{mv}$ / K$_2$ et une rotation de phase de $\phi_{mv}$ / K$_2$

L'utilisation d'un diviseur de fréquence non intégré dans le modulateur est, pour certaines modulations, à l'origine d'une dissymétrie dans le spectre de fréquence qui se traduit notamment par un décalage de la fréquence par rapport à l'origine et/ou une dissymétrie au niveau des lobes secondaires du spectre.

Pour compenser ces défauts, la chaîne d'émission peut alors comporter un dispositif adapté à générer un sens de rotation de phase aléatoire pour passer d'un état à un autre et/ou adapté à déterminer les formants permettant d'optimiser les transitions entre les états logiques et éviter la dissymétrie au niveau des lobes secondaires.

Il en résulte une optimisation des transitions entre les états logiques et les passages entre les différents états sur toute la constellation des états de la modulation utilisée et un sens de rotation qui n'est pas toujours identique. L'utilisation d'un sens de rotation aléatoire permet notamment de recentrer la fréquence.

Le sens de rotation de phase pour rejoindre les différents points de la constellation des états de phase est déterminé par exemple aléatoirement par un procédé de précodage des données.

La fonction formant utilisée pour passer d'un état à l'autre est telle que les trajets et les sens de parcours de phase pour aller aux différents points de la constellation choisie sont répartis aléatoirement entre les différents états afin d'obtenir un spectre le plus symétrique possible après division de fréquence et multiplication de fréquence.

Le trajet est déterminé pour modifier la densité spectrale de puissance afin notamment de réduire le niveau des lobes secondaires de la densité spectrale du signal émis.

Le sens de rotation de phase est déterminé par tirage aléatoire après détermination du trajet à parcourir.

Ceci s'applique en particulier pour les modulations BPSK ou QPSK ou encore pour toute autre modulation générant des dissymétries dans le spectre des fréquences.

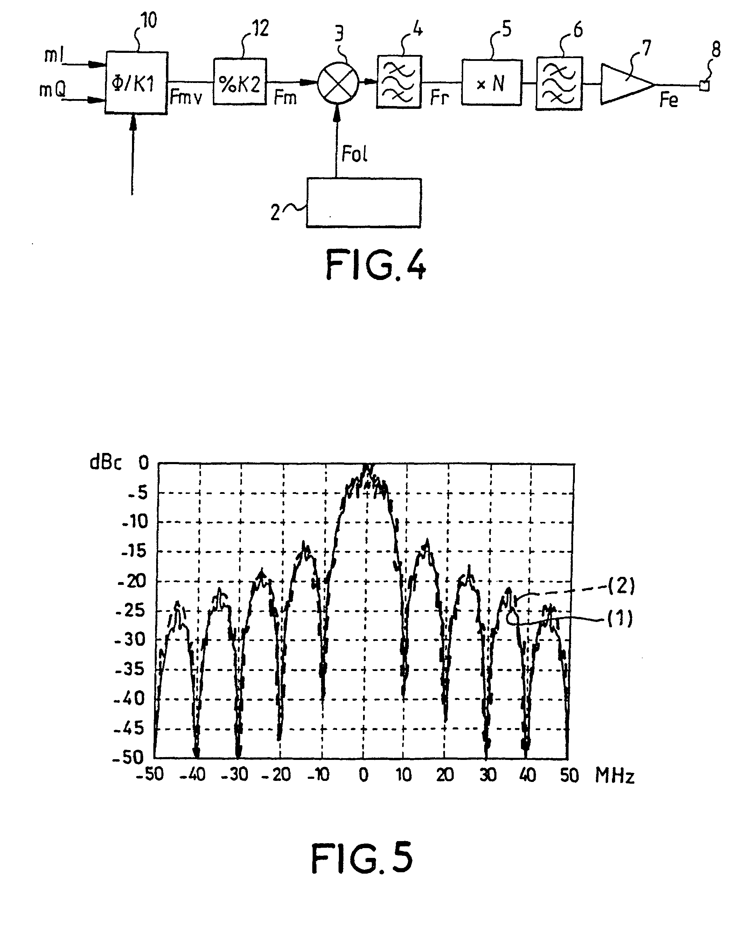

La figure 4 schématise une troisième variante de réalisation d'une structure d'émetteur permettant cette même modulation par un mixage des deux variantes décrites aux figures 2 et 3. Dans ce cas, la division de phase est répartie entre le diviseur de phase K$_1$ intégré dans le modulateur vectoriel 10 et un diviseur de fréquence K$_2$ placé entre le modulateur vectoriel 10 et le mélangeur 3 de transposition : les facteurs de division K$_1$ et K$_2$ étant choisis pour que K$_1$*K$_2$ = N, le facteur de multiplication du multiplieur de fréquence. Nous obtenons bien dans ce cas une modulation de phase égale à $\phi_m$ /N.

En pratique, dans tous les exemples de réalisation précités, le diviseur de fréquence peut être réalisé par des circuits logiques à base de bascules permettant de mémoriser, et donc de compter, les passages par zéro du signal à son entrée. Le diviseur divise l'information de phase mais peut perdre généralement l'information de modulation de d'amplitude car il ne traite que les transitions. Pour remédier à cet inconvénient qui entraîne une transformation de la modulation initiale avant division, il est possible d'utiliser un modulateur vectoriel adapté à générer une modulation à amplitude constante.

Le procédé mis en oeuvre au niveau d'un émetteur peut comporter les étapes suivantes :

1) appliquer un formant au message binaire à émettre afin d'obtenir deux signaux élémentaires modulants $m_Q$ et $m_I$,
2) diviser le signal modulé par un coefficient K égal ou sensiblement égal au coefficient de multiplication N utilisé plus loin dans la chaîne d'émission,
3) transposer le signal en fréquence, à l'aide de la fréquence $F_{ol}$ de l'oscillateur,
4) multiplier le signal transposé en fréquence par le coefficient multiplicateur N,
5) émettre le signal après amplification au niveau requis d'émission.

Les étapes de modulation et de division peuvent être réalisées en même temps.

**Exemple d'application dans le cadre d'une modulation de phase de type BPSK**

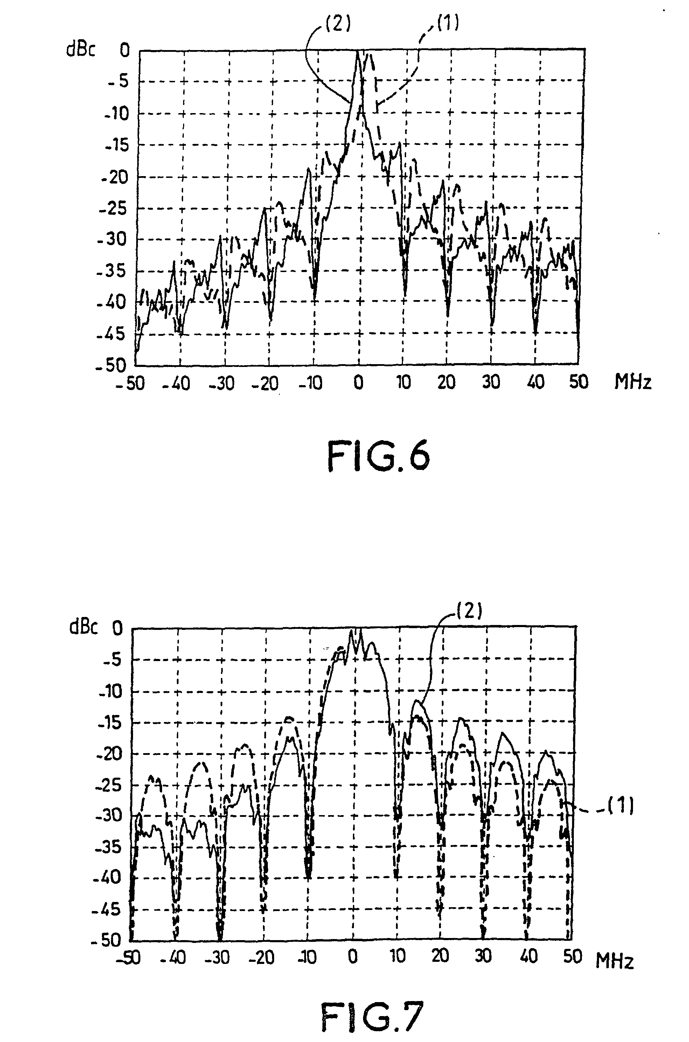

Dans le cas d'une modulation de type BPSK à 2 états de phase, la division du signal modulant par un facteur $K_2$=2, introduit une constellation à 4 états de phase en sortie du diviseur. La modulation BPSK possède une constellation à 2 états de phase : la division par $K_2$=2 introduit une ambiguïté de phase égale à $\pi$ (2$\pi$/$K_2$). Cette ambiguïté est levée après la multiplication par 2. En pratique, cette division entraîne une dissymétrie de la densité spectrale de puissance du signal utile inhérente à la répartition des transitions entre les états de la constellation initiale.
Dans le cas où la modulation BPSK divisée par $K_2$ est réalisée directement par le modulateur vectoriel, la modulation peut générer une constellation à 2 états de phase par exemple exp(+j ($\pi$/2)/$K_2$) et exp(-j ($\pi$/2)/$K_2$). Cette modulation à une densité spectrale de puissance de type sin(x)/x symétrique par rapport à la porteuse avec une raie à la fréquence de la porteuse.
Dans le cas où la modulation BPSK est réalisée par le modulateur vectoriel et la division de fréquence par un diviseur numérique $K_2$, le modulateur génère une constellation à 2 états de phases par exemple exp(+j ($\pi$/4)) et exp(-j (3$\pi$/4)). La division par $K_2$=2 a pour effet de créer une constellation avec 4 états de phase correspondant par exemple au point exp(+j ($\pi$/4), exp(-j ($\pi$/4), exp(+j (3$\pi$/4)) et exp(-j (3$\pi$/4)). La modulation de phase avec des sauts de phase de +/-i *$\pi$/2, ainsi réalisée, présente une dissymétrie liée au caractère non aléatoire des transitions entre états: dissymétrie de la densité spectrale de puissance du signal par rapport à sa fréquence centrale et décalage de la fréquence centrale du spectre.
La dissymétrie de la densité spectrale de puissance est liée à l'impossibilité physique d'obtenir une modulation de phase BPSK parfaite. Pour aller d'un point à l'autre de la constellation, le modulateur BPSK va imposer un sens de rotation de phase correspondant au passage du point à +$\pi$/4 au point à -3$\pi$/4 et un sens de rotation de phase correspondant au passage du point à -3$\pi$/4 au point +$\pi$/4 : en pratique la constellation ne peut être parfaitement nulle, le point « zéro » ne peut être atteint.
En considérant une modulation BPSK réalisée à partir d'un modulateur vectoriel parfait associé à un même message sur ses deux voies de modulation I et Q, l'introduction d'un filtrage différent entre les voies I et Q va entraîner un sens de rotation pour aller d'un point de la constellation à l'autre. Ce sens de rotation est identique entre les deux états mais le fait d'intervertir les filtres fait changer le sens de rotation pour aller d'un point à l'autre de la constellation.
A titre d'exemple, les figures 5 et 6 donnent respectivement les allures des spectres du signal modulant BPSK avant et après division par 2 en fonction des filtrages réalisés sur les signaux I et Q du modulateur vectoriel.
Les conditions d'obtention de ces courbes tracées dans un diagramme densité spectrale exprimée en dBc en fonction de la fréquence $F_m$ rapportée à sa porteuse en MHz sont les suivantes :

Figure 5 :

**Paramètres généraux de simulation:**

- modulation BPSK brut (I=Q sans formant)
- message binaire aléatoire 10 Mbits par seconde sur porteuse à 200MHz
- fréquence centrale 200MHz et fréquence d'échantillonnage 4GHz

**Paramètres des courbes :**

- courbe 1 : filtrage bande de base 50MHz voie I et 100MHz voie Q
- courbe 2 : filtrage bande de base 100MHz voie I et 50MHz voie Q

Figure 6 :

**Paramètres généraux de simulation:**

- modulation BPSK brut (I=Q) après diviseur de fréquence par K2=2
- message binaire aléatoire 10 Mbits par seconde sur porteuse à 200MHz
- fréquence centrale 100MHz et fréquence d'échantillonnage 4GHz

**Paramètres des courbes :**

- courbe 1 : filtrage bande de base 50MHz voie I et 100MHz voie Q
- courbe 2 : filtrage bande de base 100MHz voie I et 50MHz voie Q

La densité spectrale de puissance après division possède des discontinuités aux fréquences multiples du débit binaire : elles changent de sens suivant sens de rotation de la constellation.

Le fait de garder le même sens de rotation pour aller d'un état à l'autre entraîne un décalage en fréquence du spectre. Ce décalage en fréquence dépend de la nature du message et plus particulièrement du nombre moyen de transition entre états. Le décalage maximum de fréquence correspond à un message alternant les 2 états logiques : dans ce cas, la phase du signal modulant tourne de $\pi$ radians par bit par rapport à la porteuse et par conséquent le décalage en fréquence vaut donc

$$\Delta F = (1/2\pi) * (\Delta\Phi/\Delta t)/N = (F\text{débit}/2)/N.$$

La figure 7 donne l'allure du spectre de la modulation BPSK initiale et du spectre après division par 2 et multiplication par 2 pour une valeur de filtrage des voies I et Q de modulation.

Conditions d'obtention des courbes de la figure 7 :

**Paramètres généraux de simulation:**

- modulation BPSK brut I=Q mais filtrage bande de base 100MHz voie I et 50MHz voie Q
- message binaire aléatoire 10 Mbits par seconde sur porteuse à 200MHz
- fréquence centrale 200MHz et fréquence d'échantillonnage 4GHz

**Paramètres des courbes :**

- courbe 1 : modulation BPSK initiale en sortie du modulateur vectoriel
- courbe 2 : modulation BPSK après diviseur par 2 et multiplieur par 2

Une dissymétrie est constatée essentiellement entre les lobes secondaires mais globalement le spectre est centré sur la fréquence porteuse.

Pour rendre le spectre de la modulation plus symétrique en sortie du diviseur, et donc plus symétrique en sortie du multiplieur, il faut optimiser les transitions entre les états logiques et s'assurer que les passages entre les différents états se font sur toute la constellation et que le sens de rotation de phase n'est pas toujours identique.

Dans le cas d'une modulation BPSK, le fait de choisir un sens de rotation différent pour le passage entre les deux états symétrise le spectre divisé (trajet identique pour aller d'un point à l'autre mais avec un sens de rotation différent). Mais par contre, des raies apparaissent aux fréquences multiples du débit binaire (par rapport à la porteuse). Pour supprimer ces raies multiples du débit binaire, il faut répartir aléatoirement le sens de passage d'un état à l'autre.

L'amélioration sur la symétrie de la densité spectrale de puissance d'une modulation réalisée par une division de fréquence suivie d'une multiplication de fréquence repose donc sur une répartition équiprobable des deux sens de rotations de phase pour passer d'un état à un autre: Les trajets entre les états étant, bien sûr, symétriques.

Pour certaines modulation de phase, où il existe par exemple un pré codage des données avant le modulateur, ses conditions peuvent être remplies. Pour d'autres modulations, telles que les modulations BPSK ou QPSK, le sens de rotation de phase pour un saut de $\pi$ dépend des dissymétries du modulateur et il est toujours identique.

Imposer un trajet, pour aller d'un point de la constellation à un autre, revient à filtrer le signal modulant et donc à filtrer la densité spectrale de la modulation initiale. Si ce filtrage n'affecte pas l'amplitude du signal modulé, la modulation issue du modulateur vectoriel est conservée tout au long de la chaîne de transmission même si la chaîne comporte, comme dans notre cas, un diviseur de fréquence, un multiplicateur de fréquence ou un amplificateur saturé.

Pour obtenir un signal modulé avec une amplitude constante, il suffit que les signaux modulants $m_I(t)$ et $m_Q(t)$ vérifient à chaque instant la relation $|m_I(t) + jm_Q(t)| = 1$, ce qui correspond à une modulation de phase ou de fréquence $\phi_{0m}(t)$ telle que $m_I(t) + jm_Q(t) = \exp(+j\phi_m(t))$. Du point de vu de la constellation, le fait de générer un signal à amplitude constante revient à se déplacer sur un cercle. Le choix du filtrage revient à déterminer une relation, fonction du temps, de la phase du signal modulant.

Dans le cas de l'exemple précité de la modulation BPSK, des exemples de relations de phase permettant de modifier l'encombrement spectral de la modulation et de symétriser la densité spectrale une fois divisée sont données ci-après.

Pour ces exemples, le sens de rotation de phase entre deux états est déterminé en comparant l'état actuel avec l'état précédent et en choisissant le sens de rotation de phase entre les états par un tirage aléatoire.

Pour une modulation BPSK, le tableau 1 donne la relation de phase sur la durée d'un bit en fonction de l'état de ce bit $x_k$ et du bit précédent $x_{k-1}$, du résultat du tirage aléatoire $TA_k$ ainsi que le formant du signal modulant formant (t). La fonction formant(t) correspond à la relation de phase élémentaire permettant de passer d'un état de phase à un autre. Elle est définie sur la durée d'un bit et son amplitude est normalisée à 1, sachant que dans le cas de la modulation BPSK la variation de phase sur un bit est de $\pi$ radians.

Tableau 1 :

| Les différents états de phase d'une modulation BPSK avec formant et sens de rotation de phase aléatoire. | | | | |
|---|---|---|---|---|
| Bit actuel $x_k$ | Bit précédent $x_{k-1}$ | Résultat tirage aléatoire $TA_k$ | Phase $\phi_{0m}$ du signal modulant sur la durée du bit $t \in [t_k, t_{k+1}]$ | Allure de la Phase sur la durée du bit |
| 0 | 0 | 0 ou 1 | $\Phi_k(t) = \Phi_{k-1}(t=Tbit) = 0$ | Phase constante |
| 0 | 1 | 0 | $\Phi_k(t) = + \pi * \text{formant}(t)$ | Transition 0 à $\pi$ |
| 0 | 1 | 1 | $\Phi_k(t) = - \pi * \text{formant}(t)$ | Transition 0 à $-\pi$ |
| 1 | 1 | 0 ou 1 | $\Phi_k(t) = \Phi_{k-1}(t=Tbit) = \pi$ ou $-\pi$ | Phase constante |
| 1 | 0 | 0 | $\Phi_k(t) = + \pi * [1-\text{formant}(t)]$ | Transition $\pi$ à 0 |
| 1 | 0 | 1 | $\Phi_k(t) = - \pi * [1-\text{formant}(t)]$ | Transition $-\pi$ à 0 |

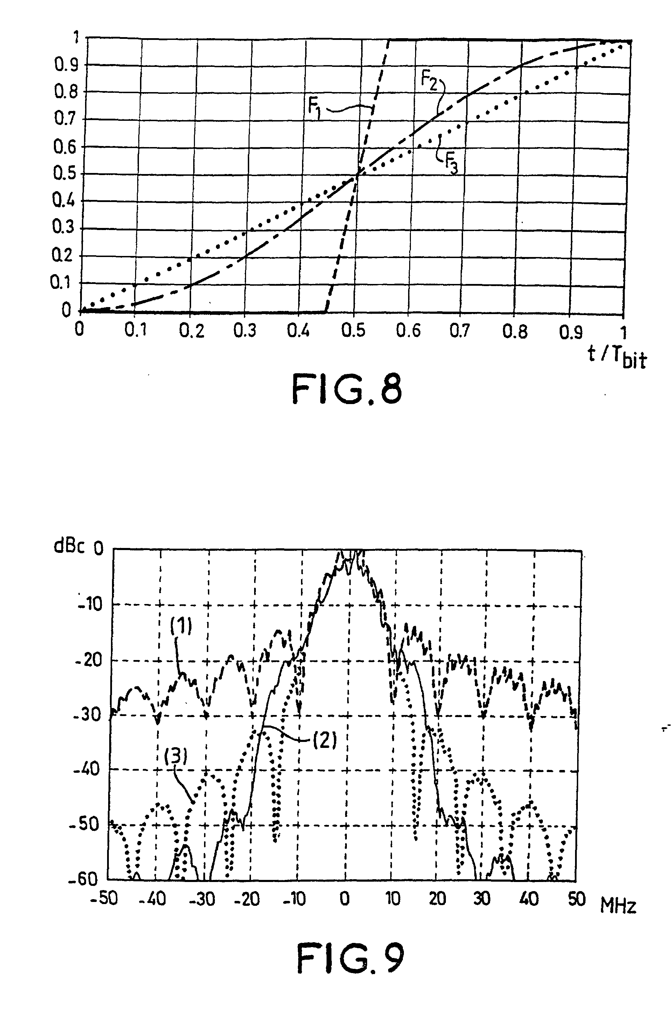

La figure 8 donne une représentation, à titre d'illustration, de 3 types de formant: un formant $F_1$ de type "temps de monté", un formant $F_2$ de type "cosinus" et un formant $F_3$ de type "phase linéaire". Les expressions temporelles de ces formants sont données dans le tableau 2.

Tableau 2 :

| Expressions de formants possibles pour la modulation BPSK | | |
|---|---|---|
| **Type de formant** | **Expression du formant en fonction de x = t/Tbit** | |
| 1) cas: formant de type "temps de monté" | Formant(x)=0 | pour $x \in [0, (1-x_m)/2]$ |
| | Formant(x)=(1/$x_m$) * [ x - (1-$x_m$)/2 ] | pour $x \in [(1-x_m)/2, (1+x_m)/2]$ |
| | Formant(x)=1 | pour $x \in [(1+x_m)/2, 1]$ avec $x_m$=Tmonté/Tbit |

Tableau 2 :  (suite)

| Expressions de formants possibles pour la modulation BPSK | | |
|---|---|---|
| **Type de formant** | **Expression du formant en fonction de x = t/Tbit** | |
| 2) cas: "cosinus" | Formant(x)=(1/2)*[1 - cos ($\pi$ x)] | pour x$\in$ [0, 1/2] |
| | Formant(x)=(1/2)*[1 + cos ($\pi$(1-x))] | pour x$\in$[1/2, 1] |
| 3) cas: formant de type "phase linéaire" | Formant(x)= x | pour x$\in$ [0, 1] |

La figure 9 donne l'allure des spectres de la modulation BPSK obtenus par simulation pour les 3 types de formants présentés. Le choix d'un formant sur la modulation de phase permet de réduire le niveau des lobes secondaires lointains de manière significative.

Conditions d'obtention des courbes de la figure 9 :

**Paramètres généraux de simulation:**

- modulation BPSK avec formant
- message binaire aléatoire 10 Mbits par seconde sur porteuse à 200MHz
- fréquence centrale 200MHz et fréquence d'échantillonnage 4GHz

**Paramètres des courbes :**

- courbe 1 : modulation BPSK avec formant de type "temps de monté" (Tm=10%)
- courbe 2 : modulation BPSK avec formant de type "cosinus"
- courbe 3 : modulation BPSK avec formant de type "phase linéaire"

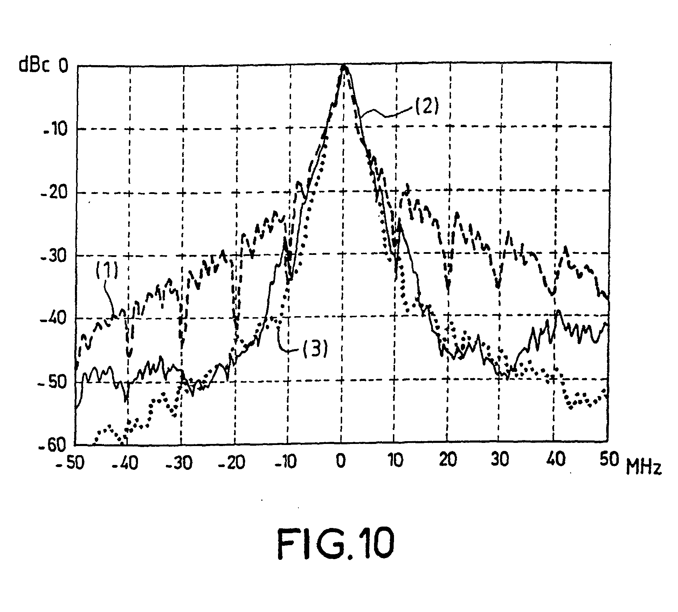

La figure 10 donne l'allure des spectres de la modulation BPSK après division par 2 pour les 3 types de formants présentés. L'introduction du tirage aléatoire pour le sens de rotation de phase permet d'obtenir une meilleure symétrie de la densité spectrale et une fréquence centrale après division égale à la fréquence porteuse sans modulation (en sortie de diviseur).

Conditions d'obtention des courbes de la figure 10 :

**Paramètres généraux de simulation:**

- modulation BPSK avec formant
- message binaire aléatoire 10 Mbits par seconde sur porteuse à 200MHz
- fréquence centrale 200MHz et fréquence d'échantillonnage 4GHz

**Paramètres des courbes :**

- courbe 1 : modulation BPSK avec formant de type "temps de monté" (Tm=10%)
- courbe 2 : modulation BPSK avec formant de type "cosinus"
- courbe 3 : modulation BPSK avec formant de type "phase linéaire"

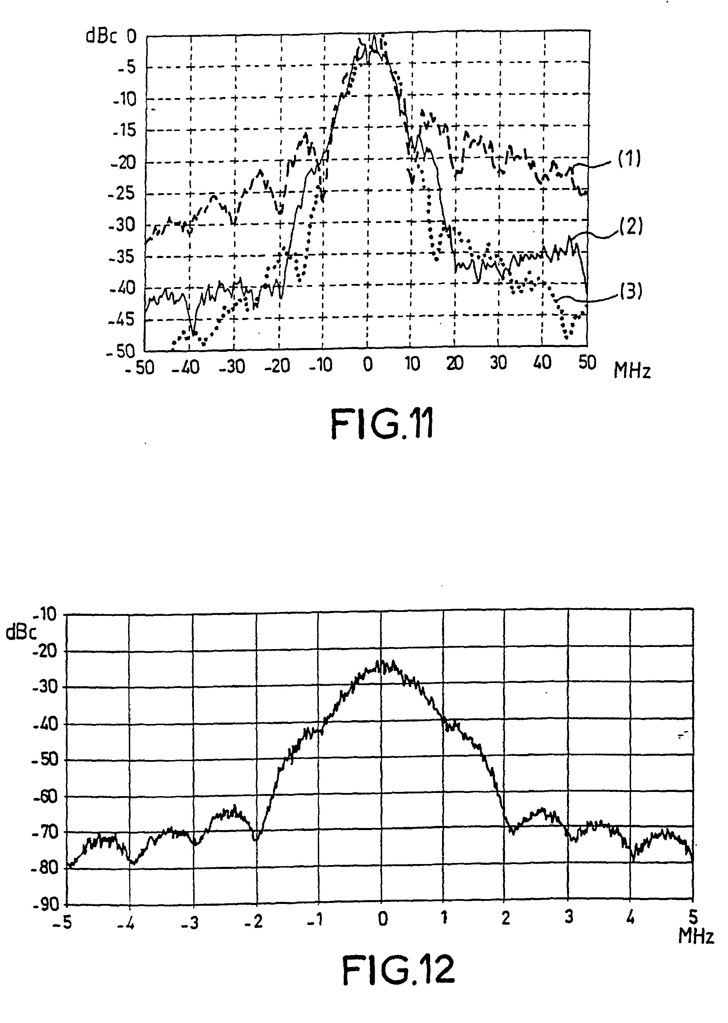

La figure 11 donne l'allure des spectres de la modulation BPSK après division par 2 et ensuite multiplication par 2 pour les 3 types de formants présentés.

Conditions d'obtention des courbes de la figure 11

**Paramètres généraux de simulation:**

- modulation BPSK avec formant
- message binaire aléatoire 10 Mbits par seconde sur porteuse à 200MHz
- fréquence centrale 200MHz et fréquence d'échantillonnage 4GHz

**Paramètres des courbes :**

- courbe 1 : modulation BPSK avec formant de type "temps de monté" (Tm=10%)
- courbe 2 : modulation BPSK avec formant de type "cosinus"
- courbe 3 : modulation BPSK avec formant de type "phase linéaire"

La figure 12 donne le résultat d'une densité spectrale obtenue avec une modulation BPSK avec formant de type "cosinus" et un tirage aléatoire du sens de rotation de phase. Dans cette réalisation avec un débit utile de 1Mbits/s, le signal utile est généré par un modulateur vectoriel à 1890 MHz , il est divisé par un diviseur de fréquence par $K_2$=16, puis ce signal est transposé à l'aide d'un oscillateur local à Frf=2375MHz afin d'obtenir après multiplication par N=16 et donc à Fe =38 GHz un signal modulé BPSK filtré en millimétrique.

**Revendications**

1. Equipement de radiofréquence comportant au moins un émetteur d'un ou de plusieurs signaux porteurs de l'information comportant au moins :

   o un modulateur adapté à moduler le ou les signaux porteurs de l'information à une fréquence ($F_m$, $F_{mv}$) ;
   o un dispositif (10, 12) disposé après le modulateur et adapté à diviser la fréquence ou la fréquence et la phase du ou des signaux modulés par un coefficient ($K_1$, $K_2$) ;
   o un dispositif de transposition du ou des signaux modulés divisés à une fréquence ($F_r$); un dispositif de multiplication de la fréquence du ou des signaux modulés, divisés et transposés par un coefficient (N) afin d'obtenir un signal à une fréquence d'émission ($F_e$) ;
   o un dispositif (9) adapté à précoder le ou les signaux porteurs de l'information de façon telle que le sens de rotation de phase pour rejoindre les différents points de la constellation des états de phase de la modulation est déterminé de manière aléatoire.

2. Equipement selon la revendication 1 comportant un dispositif (3) de transposition en fréquence du ou des signaux utiles modulés et divisés, situé entre le diviseur et le multiplieur.

3. Procédé d'émission d'un ou de plusieurs signaux porteurs de l'information comportant au moins les étapes suivantes:

   • moduler le ou les signaux porteurs de l'information à une fréquence ($F_m$, $F_{mv}$) ;
   • diviser la fréquence ou la fréquence et la phase du ou des signaux utiles modulés par un coefficient ($K_1$,$K_2$) ;
   • transposer le ou les signaux modulés divisés ($S'_3$) à une fréquence ($F_r$) ;
   • multiplier la fréquence du ou des signaux modulés, divisés et transposés, par un coefficient (N) afin d'obtenir un signal à une fréquence d'émission ($F_e$) ;
   • précoder le ou les signaux porteurs de l'information de façon telle que le sens de rotation de phase pour rejoindre les différents points de la constellation des états de phase de la modulation est déterminé de manière aléatoire.

4. Procédé selon la revendication 3 **caractérisé en ce que** les trajets et les sens de rotation de phase, pour aller aux différents points de la constellation choisie, sont repartis aléatoirement entre les différents états afin d'obtenir un spectre le plus symétrique possible après division de fréquence et multiplication de fréquence.

5. Procédé selon l'une des revendications 3 ou 4 **caractérisé en ce que** le trajet est déterminé pour modifier la densité spectrale de puissance afin, notamment, de réduire le niveau des lobes secondaires de la densité spectrale du signal utile.

**6.** Procédé selon les revendications 3 à 5 **caractérisé en ce que** le sens de rotation de phase est déterminé par tirage aléatoire après détermination du trajet à parcourir.

**7.** Procédé selon l'une des revendications 3 à 6 **caractérisé en ce que** la modulation du signal utile est réalisée par un modulateur vectoriel permettant une modulation à amplitude constante.

**8.** Application du procédé selon les revendications 3 à 7 à une modulation de type BPSK ou QPSK.

**Claims**

**1.** Radiofrequency equipment comprising at least one transmitter of one or more information-carrying signals, comprising at least:

- a modulator adapted to modulate the information-carrying signal(s) at a frequency ($F_m$, $F_{mv}$);
- a device (10, 12) placed after the modulator and adapted to divide the frequency or the frequency and the phase of the modulated signal(s) by a coefficient ($K_1$, $K_2$);
- a device for transposing the modulated and divided signal(s) to a frequency ($F_r$);
- a device for multiplying the frequency of the modulated, divided and transposed signal(s) by a coefficient (N) so as to obtain a signal at a transmission frequency ($F_e$); and
- a device (9) adapted to precede the information-carrying signal(s) in such a way that the phase rotation direction for joining the different points of the constellation of modulation phase states is determined in a random way.

**2.** Equipment according to Claim 1, comprising a device (3) for frequency-transposing the modulated and divided useful signal(s), the said device being placed between the divider and the multiplier.

**3.** Method of transmitting one or more information-carrying signals, comprising at least the following steps of:

- modulating the information-carrying signal(s) at a frequency ($F_m$, $F_{mv}$);
- dividing the frequency, or the frequency and the phase, of the modulated useful signal(s) by a coefficient ($K_1$, $K_2$);
- transposing the modulated and divided signal(s) ($S'_3$) to a frequency ($F_r$);
- multiplying the frequency of the modulated, divided and transposed signal(s) by a coefficient (N) so as to obtain a signal at a transmission frequency ($F_e$); and
- precoding the information-carrying signal(s) in such a way that the direction of phase rotation to join up the various points of the constellation of modulation phase states is determined in a random way.

**4.** Method according to Claim 3, **characterized in that** the paths and the directions of phase rotation, in order to go to the various points of the chosen constellation, are distributed randomly between the various states so as to obtain the most symmetrical spectrum possible after frequency division and frequency multiplication.

**5.** Method according to either of Claims 3 and 4, **characterized in that** the path is determined in order to modify the spectral power density so as in particular to reduce the level of the side lobes of the spectral density of the useful signal.

**6.** Method according to Claims 3 to 5, **characterized in that** the direction of phase rotation is determined, by random edition, after the path to be taken has been determined.

**7.** Method according to one of Claims 3 to 6, **characterized in that** the modulation of the useful signal is carried out by a vector modulator allowing constant amplitude modulation.

**8.** Application of the method according to Claims 3 to 7 to a modulation of the BPSK or QPSK type.

**Patentansprüche**

1. Radiofrequenzausstattung, die zumindest einen Sender für ein oder mehrere Information tragende Signale umfasst, die mindestens Folgendes umfasst:

   - einen entsprechenden Modulator, der das oder die Information tragenden Signale auf eine Frequenz ($F_m$, $F_{mv}$) modulieren kann;

   - eine Vorrichtung (10, 12), angeordnet nach dem Modulator, die die Frequenz oder die Frequenz und die Phase des oder der modulierten Signale durch einen Koeffizienten ($K_1$, $K_2$) teilen kann;

   - eine Vorrichtung zur Frequenzumsetzung des oder der modulierten, geteilten Signale auf eine Frequenz ($F_r$), eine Frequenzmultiplikationsvorrichtung des oder der modulierten, geteilten und durch einen Koeffizienten (N) frequenzumgesetzten Signale, um ein Signal mit einer Sendefrequenz ($F_e$) zu erzielen;

   - eine Vorrichtung (9), die das oder die Information tragenden Signale derart vorcodieren kann, dass die Phasendrehrichtung zum Erreichen der verschiedenen Punkte der Konstellation der Phasenzustände der Modulation nach dem Zufallsprinzip bestimmt wird.

2. Ausstattung nach Anspruch 1, umfassend eine Vorrichtung (3) zur Frequenzumsetzung des oder der modulierten, geteilten Nutzsignale, die zwischen dem Teiler und dem Multiplikator liegt.

3. Verfahren zum Senden eines oder mehrerer Information tragender Signale, das zumindest die folgenden Schritte umfasst:

   - Modulieren des oder der Information tragenden Signale auf eine Frequenz ($F_m$, $F_{mv}$);

   - Teilen der Frequenz oder der Frequenz und der Phase des oder der durch einen Koeffizienten (K1, $K_2$) modulierten Nutzsignale;

   - Frequenzumsetzung des oder der geteilten modulierten Signale ($S'_3$) auf eine Frequenz ($F_r$);

   - Multiplizieren der Frequenz des oder der modulierten, geteilten und frequenzumgesetzten Signale mit einem Koeffizienten (N), um ein Signal mit einer Sendefrequenz ($F_e$) zu erzielen;

   - Vorcodieren des oder der Information tragenden Signale derart, dass die Phasendrehrichtung zum Erreichen der verschiedenen Punkte der Konstellation der Phasenzustände der Modulation nach dem Zufallsprinzip bestimmt wird.

4. Verfahren nach Anspruch 3, **dadurch gekennzeichnet, dass** die Bahnen und die Phasendrehrichtungen nach dem Zufallsprinzip auf die verschiedenen Zustände verteilt werden, um zu den verschiedenen Punkten der ausgewählten Konstellation zu gehen, um nach dem Frequenzteilen und Frequenzmultiplizieren ein möglichst symmetrisches Spektrum zu erzielen.

5. Verfahren nach einem der Ansprüche 3 oder 4, **dadurch gekennzeichnet, dass** die Bahn bestimmt wird, um die spektrale Leistungsdichte zu modifizieren und insbesondere das Niveau der Sekundärkeulen der spektralen Dichte des Nutzsignals zu verringern.

6. Verfahren nach den Ansprüchen 3 bis 5, **dadurch gekennzeichnet, dass** die Phasendrehrichtung durch Zufallsauslosen nach dem Bestimmen der zu durchlaufenden Bahn bestimmt wird.

7. Verfahren nach einem der Ansprüche 3 bis 6, **dadurch gekennzeichnet, dass** die Modulation des Nutzsignals durch einen vektoriellen Modulator durchgeführt wird, der eine konstante Amplitudenmodulation erlaubt.

8. Anwendung des Verfahrens nach den Ansprüchen 3 bis 7 auf eine Modulation des Typs BPSK oder QPSK.

FIG.1

FIG.2

FIG.3

FIG.4

FIG.5

FIG.6

FIG.7

FIG.8

FIG.9

FIG.10

FIG.11

FIG.12